# EUROPÄISCHE PATENTSCHRIFT

(11) **EP 0 404 985 B1**
(45) Veröffentlichungstag und Bekanntmachung des Hinweises auf die Patenterteilung: **13.01.1993**
(21) Anmeldenummer: 89111870.5
(22) Anmeldetag: 29.06.1989
(51) Int. Cl.: H01L 23/544

(54) **Schaltungsanordnung zur Identifikation integrierter Halbleiterschaltkreise**
Identification circuit for integrated semiconductor circuits
Circuit pour l'identification de circuits intégrés à semiconducteur

(43) Veröffentlichungstag der Anmeldung: 02.01.1991
(73) Patentinhaber: SIEMENS AKTIENGESELLSCHAFT, 80333 München (DE)
(72) Erfinder: Pribyl, Wolfgang, Dr., A-8043 Graz (AT); Sittig, Raymond, MS EE, Deerfield, II 60015 (US)

(56) Entgegenhaltungen:
- EP-A- 0 057 645
- EP-A- 0 133 955
- EP-A- 0 144 680
- DE-A- 3 601 829
- US-A- 4 441 167

## Beschreibung

Die Erfindung betrifft eine Schaltungsanordnung zur Identifikation integrierter Halbleiterschaltkreise. Anordnungen zur Identifikation integrierter Halbleiterschaltkreise sind bereits aus EP-A 0 066 835, EP-A 0 066 836 und EP-A 0 133 955 bekannt. Weiter ist aus EP-A-0 057 645 eine Schattungsanordnung bekannt, bei der programmierbare Elemente auf einem Chip angeordnet sind, und jedes Element mit jeweils einem Anschluß des Chips verbunden ist. Sie dienen dazu, beispielsweise spezielle Schaltkreiseigenschaften wie Geschwindigkeitsklasse und mögliche Betriebsmodi des Schaltkreises auf dem Halbleiterchip selbst "notieren" zu können (z.B. Page-Mode, Nibble-Mode bei integrierten Halbleiterspeichern). Die vorgeschlagenen Lösungen haben jedoch zwei wesentliche Nachteile. Zum einen ist nur eine sehr eng begrenzte Anzahl von Identifizierungsmerkmalen in die Schaltkreise einbringbar. Zum anderen sind diese Merkmale teilweise (vgl. EP-A 0 066 835) nur auf der sogenannten Wafer-Ebene auswertbar.

Aufgabe der vorliegenden Erfindung ist es, eine Schaltungsanordnung zu schaffen, die bei minimalem Platzbedarf eine möglichst große Anzahl von Identifizierungsmerkmalen (z.B. Chargennummer) enthalten kann und deren Identifizierungsmerkmale auch dann noch auslesbar sind, wenn die Schaltkreise in ein Gehäuse eingekapselt sind.

Diese Aufgabe wird gelöst mit den im Patentanspruch 1 angegebenen Merkmalen. Vorteilhafte Aus- und Weiterbildungen sind in Unteransprüchen gekennzeichnet.

Die Erfindung wird im folgenden anhand von FIG näher erläutert. Es zeigen
FIG 1 die erfindungsgemäße Schaltungsanordnung in einem integrierten Halbleiterschaltkreis,
die FIG 2 bis 4 verschiedene Ausführungsformen der Erfindung, teilweise in codiertem Zustand.

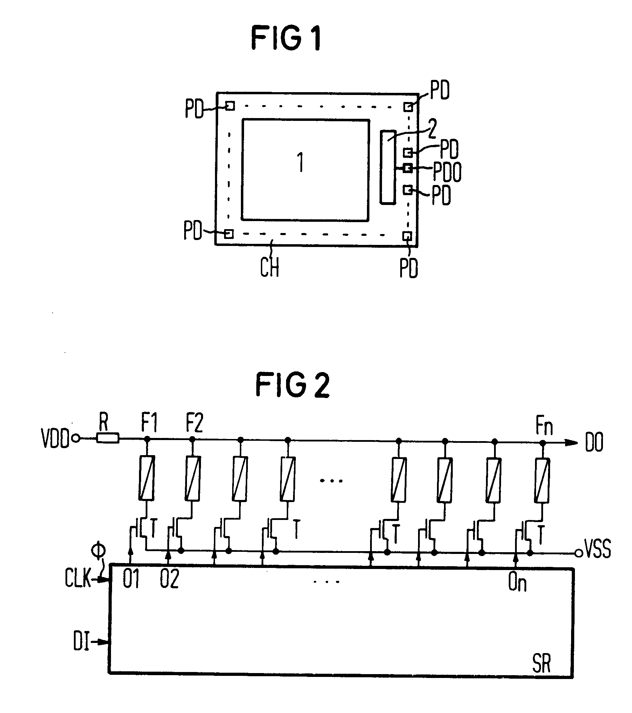

FIG 1 zeigt, stark schematisiert, in Draufsicht den Halbleiterchip CH eines integrierten Halbleiterschaltkreises mit der für den Halbleiterschaltkreis spezifischen integrierten Halbleiterschaltung 1 und deren Anschlußpads PD. Auf dem Chip CH ist weiterhin die erfindungsgemäße Schaltungsanordnung 2 dargestellt, wobei das Größenverhältnis zwischen der Schaltungsanordnung 2 und der integrierten Halbleiterschaltung 1 wesentlich zu groß bemessen ist gegenüber den technisch tatsächlich notwendigen Bedingungen. Dies dient jedoch einer Verbesserung der Anschaulichkeit. Ein als Sammelleitung DO ausgebildeter Datenausgang der Schaltungsanordnung 2 ist auf ein dieser speziell zugeordnetes Anschlußpad PDO auf dem Halbleiterchip CH geführt, so daß der Datenausgang über Anschlußpins auch baustein-extern zugänglich ist. Bei Verwendung einer geeigneten Multiplex-Einrichtung läßt sich jedoch auch ein auf dem Halbleiterchip CH bereits vorhandenes Anschlußpad PD als Anschlußpad PDO für den Datenausgang benutzen. Der Datenausgang kann auch mit Teilen der integrierten Halbleiterschaltung 1 verschaltet sein.

Die Ausführungsform nach FIG 2 zeigt die erfindungsgemäße Schaltungsanordnung 2 detaillierter. Sie enthält n (n = natürliche Zahl) programmierbare Elemente F1...Fn und ein n-stufiges Serial-Parallel-Schieberegister SR sowie n Transistoren T. Die programmierbaren Elemente F1...Fn sind einerseits mit einer den Datenausgang bildenden Sammelleitung DO verbunden und andererseits mit den Drains der Transistoren T. Die Sources der Transistoren T sind mit einem ersten Versorgungspotential VSS verbunden. Die Gates der Transistoren T sind jeweils mit einem der Parallelausgänge O1..On des Serial-Parallel-Schieberegisters SR verbunden. FIG 2 zeigt auch einen Dateneingang DI des Serial-Parallel-Schieberegisters SR und einen Takteingang CLK. Mit Hil- eines daran anlegbaren Taktsignals ⌀ läßt sich ein am Dateneingang DI anliegendes Datum bitweise durch die n Stufen des Serial-Parallel-Schieberegisters SR schieben.

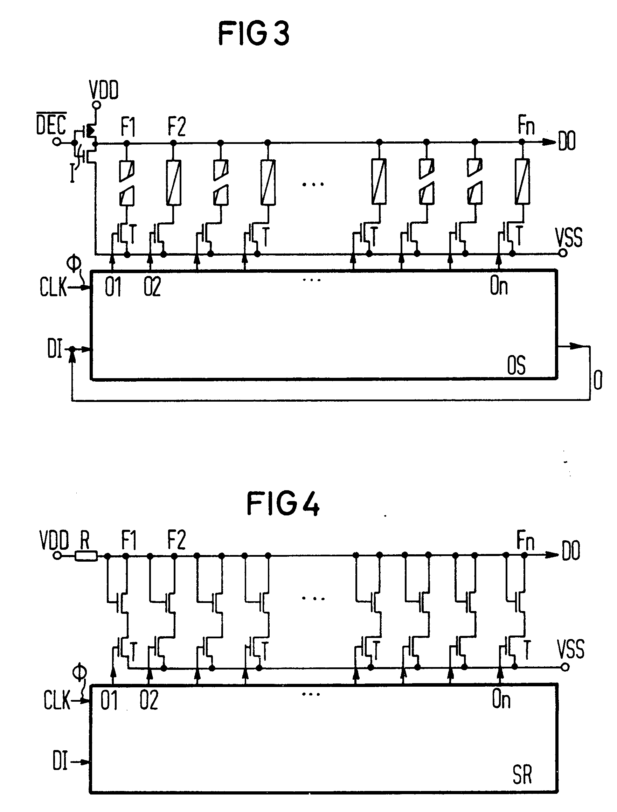

Die Erfindung ist in mehreren vorteilhaften Ausführungsformen realisierbar, die nachstehend aufgezeigt sind: Die programmierbaren Elemente F1...Fn sind in einer Ausführungsform mechanisch, thermisch oder chemisch auftrennbare Schaltelemente, insbesondere Widerstände, als Widerstand geschaltete Transistoren (FIG 4) oder Laser fuses (FIG 2,3). Sie können aber auch auftrennbare Leiterbahnen sein.

Weiterhin ist es günstig, die Sammelleitung DO als hochohmig mit einem zweiten Versorgungspotential VDD verbunden auszugestalten. In den FIG 2 und 4 ist dies über einen hochohmigen Widerstand R (Widerstandswert beispielsweise mindestens 10 mal so groß wie der eines programmierbaren Elementes F) realisiert. In der Ausführungsform nach FIG 3 ist die hochohmige Verbindung mittels eines CMOS-Inverters I realisiert, dessen p-Kanal-Transistor so dimensioniert ist, daß sein Kanalwiderstand hochohmig ist. Der Inverter I ist dabei eingangsmäßig mit einem Dekodiersignal 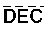 angesteuert. Soll die Identifizierung durchgeführt werden (d.h., soll der durch die programmierten programmierbaren Elemente F1...Fn dargestellte Codewert ausgelesen werden), so nimmt das Dekodiersignal 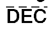 einen niedrigen Wert an, wodurch die Sammelleitung DO hochohmig mit dem zweiten Versorgungspotential VDD verbunden wird. Ansonsten nimmt das Dekodiersignal 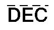 einen hohen Wert an, wodurch die Sammelleitung DO mit dem ersten Versorgungspotential VSS verbunden wird. Dadurch ist sichergestellt, daß die Sammelleitung DO stets ein definiertes Potential aufweist. Das ist insbesondere dann wichtig, wenn die Sammelleitung DO der Schaltungsanordnung 2 noch irgendwie mit sonstigen Teilen der integrierten Halbleiterschaltung 1, insbesondere mit Eingangsstufen derselben, verbunden ist (bei CMOS-Technologie darf bekanntlich kein Eingang elektrisch "floaten").

FIG 3 zeigt außerdem noch eine weitere vorteilhafte Ausgestaltung der Erfindung: anstelle des n-stufigen Serial-Parallel-Schieberegisters SR ist ein getakteter n-stufiger Oszillator OS verwendet. Ein n-stufiger Zähler ist ebenfalls verwendbar anstelle des Schieberegisters SR oder des Oszillators OS. Ein vorhandener Serialausgang O des Oszillators OS bzw. des Zählers kann dabei auf den Dateneingang DI rückgekoppelt sein, so daß sich ein Ring-Oszillator bzw. ein Ring-Zähler ergibt.

Die Erfindung ermöglicht bei Verwendung von n programmierbaren Elementen F1...Fn und einem n-stufigen Serial-Parallel-Schieberegister SR (bzw. Zähler bzw. Oszillator OS), einen Normalzustand (alle n programmierbaren Elemente F1....Fn sind nichtprogrammiert) und 2ⁿ-1 verschiedene Codewerte zu programmieren. Diese große Anzahl von Codewerten ist, bei auf dem Gebiet integrierter Halbleiterschaltungen üblichen geringen Flächenvorgaben, beim bekannten Stand der Technik nicht realisierbar.

Die programmierten Codes bzw. der (nicht-programmierte) Normalzustand lassen sich im Betrieb folgendermaßen auslesen (positive Logik angenommen): Das Serial-Parallel-Schieberegister SR wird mittels des Taktsignales ⌀ mindestens (n-1)mal vorgetaktet, wobei am Dateneingang DI eine log. 0 anliegt. Bei einem daran anschließenden nächsten Auftreten des Taktsignales ⌀ wird an den Dateneingang DI eine log. 1 angelegt, die in die erste Stufe des Serial-Parallel-Schieberegisters SR übernommen wird. Dadurch nimmt der erste Parallelausgang O1 den Wert log. 1 an, die restlichen Parallelausgänge O2...On bleiben auf log. 0. Deshalb ist der dem ersten Parallelausgang O1 zugeordnete Transistor T elektrisch leitend, während die restlichen Transistoren T gesperrt sind. Ist das erste programmierbare Element F1 nicht programmiert (wie in FIG 2 gezeigt), so gelangt das erste Versorgungspotential VSS über den dem ersten Parallelausgang O1 zugeordneten Transistor T an die Sammelleitung DO; diese nimmt den Zustand log. 0 an. Ist das erste programmierbare Element F1 jedoch programmiert (wie in FIG 3 gezeigt), so wirkt sich auf die Sammelleitung DO die hochohmige Verbindung zum zweiten Versorgungspotential VDD aus: Sie bleibt auf dem Zustand log. 1.

Beim nächsten (und allen weiteren) Auftreten des Taktsignales ⌀ wird an den Dateneingang DI eine log. 0 angelegt. Dies bewirkt, daß die log. 1, die zuvor in die erste Stufe des Serial-Parallel-Schieberegisters SR übernommen wurde, in die (jeweils) nächste Stufe des Serial-Parallel-Schieberegisters SR weitergeschoben wird, wobei in die vorherige Stufe eine log. 0 geschoben wird. Entsprechend nimmt der zweite Parallelausgang O2 (bzw. der jeweils weitere Parallelausgang O3...On) den Zustand log. 1 an, die restlichen Parallelausgänge O1,O3...On (bzw. O1, O2,O4... On, etc.) weisen den Zustand log. 0 auf. Dasjenige programmierbare Element F2...Fn, das über seinen ihm zugeordneten Transistor T mit demjenigen Parallelausgang O2...On verbunden ist, der den Zustand log. 1 aufweist, bestimmt durch seinen Zustand (programmiert - nicht-programmiert), ob die Sammelleitung DO den Wert log. 1 (programmierter Zustand) oder den Wert log. 0 (nicht-programmierter Zustand) annimmt. Auf diese Weise lassen sich die n Bits des programmierten Codewertes auslesen.

## Patentansprüche

1. Schaltungsanordnung zur Identifikation integrierter Halbleiterschaltkreise auf einem Halbleiterchip
- mit n programmierbaren Elementen (F1.. Fn) und einem n-stufigen Serial-Parallel-Schieberegister (SR) oder einem getakteten n-stufigen Oszillator (OS) oder einem n-stufigen Zähler mit einem Dateneingang (DI) und mit n Parallel-Ausgängen (O1...On),
- bei der jedes programmierbare Element (F1...Fn) einerseits mit einer gemeinsamen Leitung (DO) und andererseits jeweils mit dem Drain eines Transistors (T) verbunden ist,
- bei der die Sources der Transistoren (T) mit einem ersten Versorgungspotential (VSS) verbunden sind,
- bei der jedes Gate der Transistoren (T) mit einem der Parallel-Ausgänge (O1...On) des Serial-Parallel-Schieberegisters (SR) bzw. des Oszillators (OS) bzw. des Zählers elektrisch verbunden ist,
- bei der das Serial-Parallel-Schieberegister (SR bzw. der Oszillator (OS) bzw. der Zähler einen Takteingang (CLK) aufweist zur Steuerung der Schiebefunktion des Serial-Parallel-Schieberegisters (SR) bzw. des Oszillators (OS) bzw. des Zählers in Abhängigkeit von einem Taktsignal (⌀), das an den Takteingang (CLK) anlegbar ist, und
- bei der die gemeinsaure Leitung (DO) mit einem Anschlußpad (PDO) des Halbleiterchips elektrisch verbunden ist.

2. Schaltungsanordnung nach Anspruch 1, **dadurch gekennzeichnet,** daß die programmierbaren Elemente (F1...Fn) mechanisch, thermisch oder chemisch auftrennbare Schaltelemente sind.

3. Schaltungsanordnung nach Anspruch 2, **dadurch gekennzeichnet,** daß die auftrennbaren Schaltelemente Widerstände sind.

4. Schaltungsanordnung nach Anspruch 3, **dadurch gekennzeichnet,** daß die Widerstände als Widerstand geschaltete Transistoren sind.

5. Schaltungsanordnung nach Anspruch 1 oder 2 **dadurch gekennzeichnet,** daß die programmierbaren Elemente (F1...Fn) Laser fuses sind.

6. Schaltungsanordnung nach Anspruch 1 oder 2, **dadurch gekennzeichnet,** daß die programmierbaren Elemente (F1...Fn) auftrennbare Leiterbahnen sind.

7. Schaltungsanordnung nach einem der vorhergehenden Ansprüche, **dadurch gekennzeichnet,** daß die Sammelleitung (DO) hochohmig mit einem zweiten Versorgungspotential (VDD) verbunden ist.

8. Schaltungsanordnung nach einem der vorhergehenden Ansprüche, **dadurch** **gekennzeichnet,** daß der Oszillator (OS) bzw. Zähler ein Ring-Oszillator bzw. ein Ring-Zähler ist.

## Revendications

1. Montage pour identifier des circuits intégrés à semiconducteurs situés sur une microplaquette à semiconducteurs, comportant
- n éléments programmables (F1...Fn) et un registre à décalage série-parallèle (SR) à n étages ou un oscillateur cadencé (OS) à n étages ou un compteur à n étages, comportant une entrée de données (DI) et n sorties parallèles (O1...On),
et dans lequel
- chaque élément programmable (F1...Fn) est raccordé, d'une part, à une ligne commune (DO) et, d'autre part, respectivement au drain d'un transistor (T),
- les sources des transistors (T) sont raccordées à un premier potentiel d'alimentation (VSS),
- chaque grille des transistors (T) est raccordée électriquement à l'une des sorties parallèles (O1...On) du registre à décalage série-parallèle (SR) ou de l'oscillateur (OS) ou du compteur,
- le registre à décalage série-parallèle (SR) ou l'oscillateur (OS) du compteur possède une entrée de cadence (CLK) servant à commander la fonction de transfert du registre à décalage série-parallèle (SR), de l'oscillateur (OS) ou du compteur, en fonction du signal de cadence (φ), qui peut être appliqué à l'entrée de cadence (CLK), et
- la ligne commune (DO) est raccordée électriquement à un plot de connexion (PDO) de la microplaquette à semiconducteurs.

2. Montage suivant la revendication 1, caractérisé par le fait que les éléments programmables (F1...Fn) sont des éléments de commutation pouvant être rompus mécaniquement, thermiquement ou chimiquement.

3. Montage suivant la revendication 2, caractérisé par le fait que les éléments de commutation pouvant être rompus sont des résistances.

4. Montage suivant la revendication 3, caractérisé par le fait que les résistances sont des transistors branchés en résistance.

5. Montage suivant la revendication 1 ou 2, caractérisé par le fait que les éléments programmables (F1 ... Fn) sont des fusibles laser.

6. Montage suivant la revendication 1 ou 2, caractérisé par le fait que les éléments programmables (F1... Fn) sont des voies conductrices pouvant être rompues.

7. Montage suivant l'une des revendications précédentes, caractérisé par le fait que la ligne formant bus (DO) est raccordée selon une liaison de forte valeur ohmique à un second potentiel d'alimentation (VDD).

8. Montage suivant l'une des revendications précédentes, caractérisé par le fait que l'oscillateur (OS) ou le compteur est un oscillateur en anneau ou un compteur en anneau.

## Claims

1. Circuit arrangement for identifying integrated semiconductor circuits on a semiconductor chip
- having n programmable elements (F1...Fn) and an n-stage serial/parallel shift register (SR) or a clocked n-stage oscillator (OS) or an n-stage counter with a data input (DI) and with n parallel outputs (01...0n),
- in which each programmable element (F1... Fn) is connected, on the one hand, to a common line (D0) and, on the other hand, in each case to the drain of a transistor (T),
- in which the sources of the transistors (T) are connected to a first supply potential (VSS),
- in which each gate of the transistors (T) is electrically connected to one of the parallel outputs (01...0n) of the serial/parallel shift register (SR) or of the oscillator (OS) or of the counter,
- in which the serial/parallel shift register (SR) or the oscillator (OS) or the counter has a clock input (CLK) for controlling the shift function of the serial/parallel shift register (SR) or of the oscillator (OS) or of the counter in dependence on a clock signal (⌀) which can be applied to the clock input (CLK), and
- in which the common line (D0) is electrically connected to a terminal pad (PDO) of the semiconductor chip.

2. Circuit arrangement according to Claim 1, characterised in that the programmable elements (F1...Fn) are mechanically, thermally or chemically separable switching elements.

3. Circuit arrangement according to Claim 2, characterised in that the separable switching elements are resistors.

4. Circuit arrangement according to Claim 3, charaterised in that the resistors are transistors connected as resistor.

5. Circuit arrangement according to Claim 1 or 2, characterised in that the programmable elements (F1...Fn) are laser fuses.

6. Circuit arrangement according to Claim 1 or 2, characterised in that the programmable elements (F1...Fn) are separable conductor tracks.

7. Circuit arrangement according to one of the preceding claims, characterised in that the common line (DO) is connected in a high-impedance manner to a second supply potential (VDD).

8. Circuit arrangement according to one of the preceding claims, characterised in that the oscillator (OS) or counter is a ring oscillator or a ring counter.
